(19) Europäisches Patentamt / European Patent Office / Office européen des brevets

(11) **EP 4 290 710 A1**

(12) **EUROPEAN PATENT APPLICATION**
published in accordance with Art. 153(4) EPC

(43) Date of publication:
**13.12.2023 Bulletin 2023/50**

(21) Application number: **22874141.9**

(22) Date of filing: **28.03.2022**

(51) International Patent Classification (IPC):
**H01S 5/183** (2006.01)   **H01S 5/10** (2021.01)
**H01S 5/42** (2006.01)

(52) Cooperative Patent Classification (CPC):
**G01S 7/481; H01S 5/10; H01S 5/183; H01S 5/22; H01S 5/343; H01S 5/42**

(86) International application number:
**PCT/CN2022/083263**

(87) International publication number:
**WO 2023/050740 (06.04.2023 Gazette 2023/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.09.2021   US 202163249998 P**
**11.11.2021   CN 202111335318**

(71) Applicant: **Vertilite Co., Ltd.**
**Changzhou, Jiangsu 213000 (CN)**

(72) Inventors:
• **LIANG, Dong**
**Changzhou, Jiangsu 213000 (CN)**
• **ZHANG, Cheng**
**Changzhou, Jiangsu 213000 (CN)**

(74) Representative: **HGF**
**HGF Limited**
**1 City Walk**
**Leeds LS11 9DX (GB)**

(54) **VERTICAL CAVITY SURFACE EMITTING LASER (VCSEL) HAVING SMALL DIVERGENCE ANGLE, CHIP, AND LIGHT SOURCE FOR USE IN LIDAR SYSTEM**

(57)   Provided are a vertical-cavity surface-emitting laser (VCSEL) and a VCSEL chip with a small divergence angle and a light source for a light detection and ranging (LIDAR) system. The VCSEL includes a lower Bragg reflection layer, an active layer and an upper Bragg reflection layer. The active layer is located on a side of the lower Bragg reflection layer. The upper Bragg reflection layer is located on a side of the active layer away from the lower Bragg reflection layer. A current limiting layer is disposed inside or outside the active layer, and the current limiting layer has an opening for defining a light-emitting region. An extended cavity layer is disposed at least between the lower Bragg reflection layer and the active layer or between the upper Bragg reflection layer and the active layer, the extended cavity layer includes at least one resonant cavity inside, and the at least one resonant cavity is configured to increase the optical field intensity in the extended cavity layer. The distribution of standing wave electric field optical intensities is adjusted through the resonant cavity, so that the optical confinement factor of the current limiting layer is reduced. Different from the conventional method of simply lengthening the cavity length to reduce the divergence angle, in this method, the cavity length is increased less while the divergence angle is effectively reduced, so that the problem of simultaneous lasing of multiple longitudinal modes caused by the long cavity can be alleviated.

**FIG. 8**

## Description

The present application claims priority to United States Provisional Patent Application No. 63/249,998 filed on Sept. 29, 2021 and Chinese Patent Application No. 202111335318.1 filed with the China National Intellectual Property Administration (CNIPA) on Nov. 11, 2021, the disclosures of which are incorporated herein by reference in their entireties.

## Cross-reference and priority claim

The present patent application claims priority to United States Provisional Patent Application "Small divergence angle VCSEL with a middle DBR cavity" No. 63/249,998 filed on Sept. 29, 2021, and the disclosure of the preceding United States Provisional Patent Application is incorporated herein by reference in its entirety.

## TECHNICAL FIELD

Embodiments of the present application relate to the field of laser technology, for example, to a VCSEL and a VCSEL chip with a small divergence angle and a light source for a LIDAR system.

## BACKGROUND

Vertical-cavity surface-emitting lasers (VCSELs) can produce beams with a smaller divergence angle than light-emitting diodes (LEDs) or other incoherent light sources. Therefore, VCSELs are widely used in applications such as three-dimensional sensing, laser radar, optical communication and lighting, providing a small, compact and high-power laser source for various applications.

The full divergence angle of conventional VCSELs is usually about 20 degrees to 30 degrees. This divergence angle can satisfy the requirements of some conventional applications, however, is still relatively large for new application scenes, limiting the detection range, resolution and signal-to-noise ratio of three-dimensional sensors and laser radar. Therefore, it is desirable to further reduce the beam divergence angle of VCSELs for practical applications.

## SUMMARY

Embodiments of the present application provide a vertical-cavity surface-emitting laser (VCSEL) and a VCSEL chip with a small divergence angle and a light source for a LIDAR system.

In a first aspect, an embodiment of the present application provides a VCSEL with a small divergence angle, and the VCSEL includes a lower Bragg reflection layer, an active layer and an upper Bragg reflection layer.

The active layer is located on a side of the lower Bragg reflection layer.

The upper Bragg reflection layer is located on a side of the active layer away from the lower Bragg reflection layer; where a current limiting layer is disposed inside or outside the active layer, and the current limiting layer has an opening for defining a light-emitting region.

An extended cavity layer is disposed at least between the lower Bragg reflection layer and the active layer or between the upper Bragg reflection layer and the active layer, the extended cavity layer includes at least one resonant cavity inside, and the at least one resonant cavity is configured to increase the optical field intensity in the extended cavity layer.

In a second aspect, an embodiment of the present application provides a VCSEL chip with a small divergence angle including multiple VCSELs according to any of the first aspect, and the multiple VCSELs with a small divergence angle form a planar array arrangement; and the planar array arrangement is a regular arrangement, a random arrangement or multiple subarrays for addressing.

In a third aspect, an embodiment of the present application further provides a light source for a LIDAR system. The light source includes at least one VCSEL with a small divergence angle according to any of the first aspect or at least one VCSEL chip with a small divergence angle according to any of the second aspect.

## BRIEF DESCRIPTION OF DRAWINGS

FIG. 1 is a structural diagram of a VCSEL in the related art;

FIG. 2 is a structural diagram of a VCSEL with a small divergence angle according to an embodiment of the present application;

FIG. 3 is a structural diagram of another VCSEL with a small divergence angle according to an embodiment of the present application;

FIG. 4 is a structural diagram of another VCSEL with a small divergence angle according to an embodiment of the present application;

FIG. 5 is a structural diagram of another VCSEL with a small divergence angle according to an embodiment of the present application;

FIG. 6 is a structural diagram of another VCSEL with a small divergence angle according to an embodiment of the present application;

FIG. 7 is a structural diagram of another VCSEL with a small divergence angle according to an embodiment of the present application;

FIG. 8 is a profile showing the distribution of optical field intensities and the distribution of refractive indexes according to an embodiment of the present application;

FIG. 9 is another profile showing the distribution of optical field intensities and the distribution of refractive indexes according to an embodiment of the present application;

FIG. 10 is a structural diagram of another VCSEL with a small divergence angle according to an embodiment of the present application;

FIG. 11 is a profile showing the distribution of optical field intensities and the distribution of refractive indexes according to an embodiment of the present application; and

FIG. 12 is another profile showing the distribution of optical field intensities and the distribution of refractive indexes according to an embodiment of the present application.

DETAILED DESCRIPTION

The present application is further described in detail hereinafter in conjunction with the drawings and embodiments. It is to be understood that the embodiments described herein are intended to illustrate and not to limit the present application. Additionally, it is to be noted that to facilitate description, only part, not all, of structures related to the present application are illustrated in the drawings.

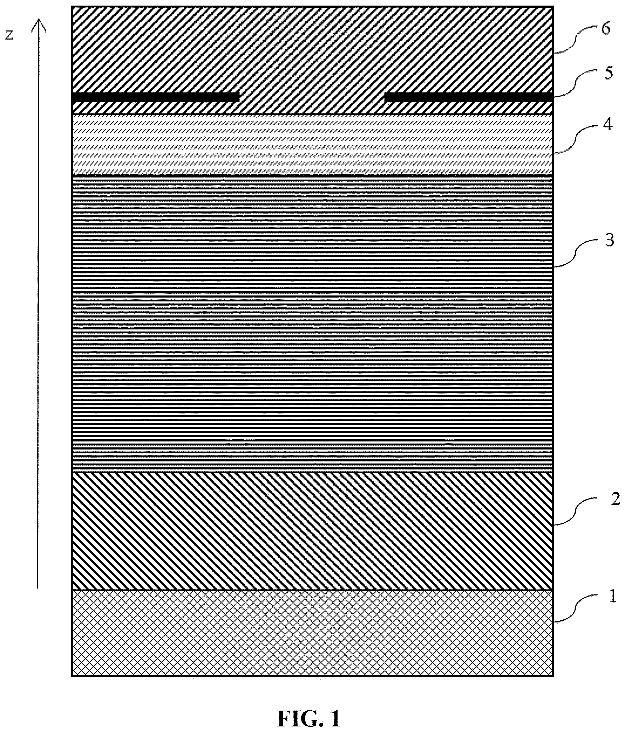

In the background art, the full divergence angle of conventional vertical-cavity surface-emitting lasers (VCSELs) is usually about 20 degrees to 30 degrees. This divergence angle can satisfy the requirements of some conventional applications, however, is still relatively large for new application scenes, limiting the detection range, resolution and signal-to-noise ratio of three-dimensional sensors and laser radar. In the related art, to reduce the divergence angle of a VCSEL beam, a common manner is to reduce the difference between effective refractive indexes inside and outside a light-emitting aperture of the VCSEL by lengthening the cavity length, thereby suppressing the generation of a higher-order mode. A beam in the higher-order mode has a larger divergence angle, and therefore, after the higher-order mode beam is suppressed, a smaller divergence angle of a beam in a lower-order mode can be achieved. FIG. 1 is a structural diagram of a VCSEL in the related art. Referring to FIG. 1, a lower Bragg reflection layer 3, an active layer 4 and an upper Bragg reflection layer 6 are disposed on the same side of a substrate 1. The upper Bragg reflection layer 6 includes a current limiting layer 5 formed by oxidizing a material with high aluminum content, such as AlGaAs, in the upper Bragg reflection layer 6, that is, AlGaAs is oxidized to form aluminum oxide. In this manner, in the layer where the current limiting layer 5 is located, AlGaAs at an opening position and the aluminum oxide at the position other than the opening position have different refractive indexes. The opening position is the light-emitting aperture of a laser, so that the effective refractive indexes inside and outside the light-emitting aperture of the VCSEL are different.

The effective refractive index is determined based on the following formula:

$$n_{eff} = \frac{\int n(z)E^2(z)dz}{\int E^2(z)dz}.$$

$n_{eff}$ represents the effective refractive index, $n(z)$ represents a refractive index in a z-axis direction, and $E^2(Z)$ represents the optical intensity in the z-axis direction.

The difference between effective refractive indexes inside and outside the light-emitting aperture of the VCSEL is determined based on the following formula:

$$\Delta n_{eff} = n_{1\_eff} - n_{2\_eff}$$

$$= \Gamma_{ox} \times (n_1 - n_2).$$

$\Delta n_{eff}$ represents the difference between effective refractive indexes inside and outside the light-emitting aperture, $n_{1\_eff}$ represents the effective refractive index of the region where the light-emitting aperture is located, $n_{2\_eff}$ represents the effective refractive index outside the light-emitting aperture, $n_1$ represents the refractive index of the material (for example,

$Al_{0.98}Ga_{0.02}As$) with high aluminum content, and $n_2$ represents the refractive index of the aluminum oxide. $\Gamma_{ox}$ represents the optical confinement factor of an oxide layer and is determined based on the following formula:

$$\Gamma_{ox} = \frac{\int_0^l n_2(z)E^2(z)dz}{\int_0^p n(z)E^2(z)dz}.$$

$l$ represents the thickness of the current limiting layer 5 in the z-axis direction, p represents the thickness of the entire optical field in the z-axis direction, and $n_2(z)$ represents the refractive index of the aluminum oxide in the z-axis direction and may be a fixed value; for example, $n_2(z)$ is equal to $n_2$.

To reduce the divergence angle of the VCSEL beam, the cavity length is lengthened in the manner of adding a middle Bragg reflection layer 2, so that the value of p can be increased and the value of $\Gamma_{ox}$ can be decreased; therefore the difference between effective refractive indexes inside and outside the light-emitting aperture can be decreased, and the generation of the higher-order mode can be suppressed. A beam in the higher-order mode has a larger divergence angle, and therefore, after the higher-order mode beam is suppressed, a smaller divergence angle of a beam in the lower-order mode can be achieved. However, the manner of lengthening the cavity length brings new problems. After the cavity length is lengthened, the spacing of longitudinal modes of lasers will also decrease, and thus the emission spectrum of the VCSEL will show multiple longitudinal modes, that is, multiple spectral peaks. In addition to the designed lasing wavelength, other undesired spectral peaks appear on one or two sides of the designed lasing wavelength, which are commonly referred to as longitudinal modes. The appearance of longitudinal modes may lead to some potential problems; for example, a temperature drift coefficient of a light source increases and the temperature stability decreases; for another example, a receiving terminal of a three-dimensional sensor or laser radar cannot recognize these longitudinal modes, resulting in reduced efficiency and crosstalk, etc.

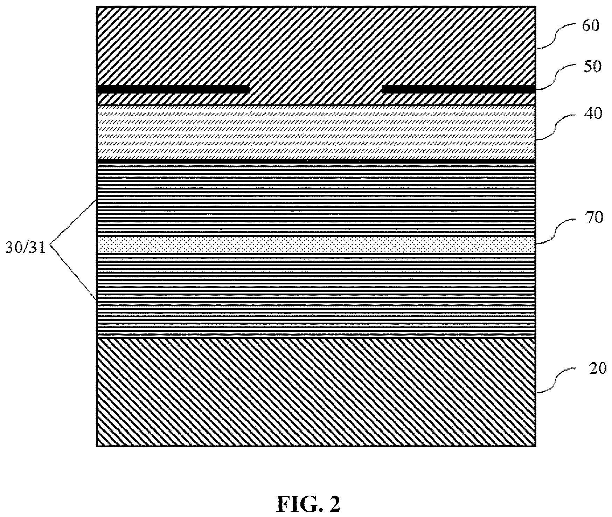

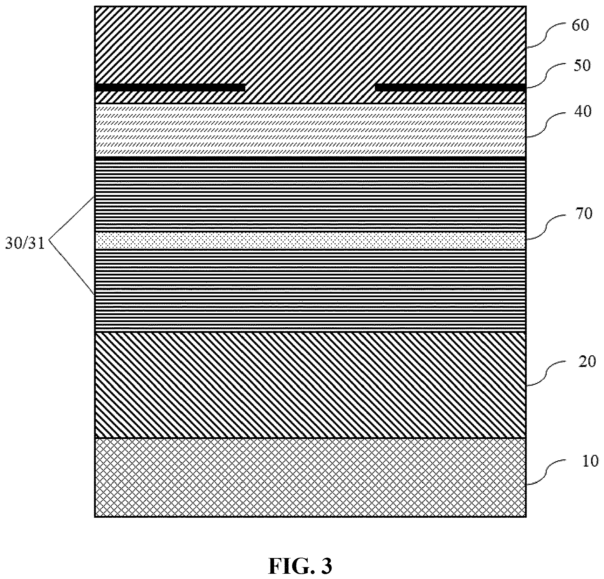

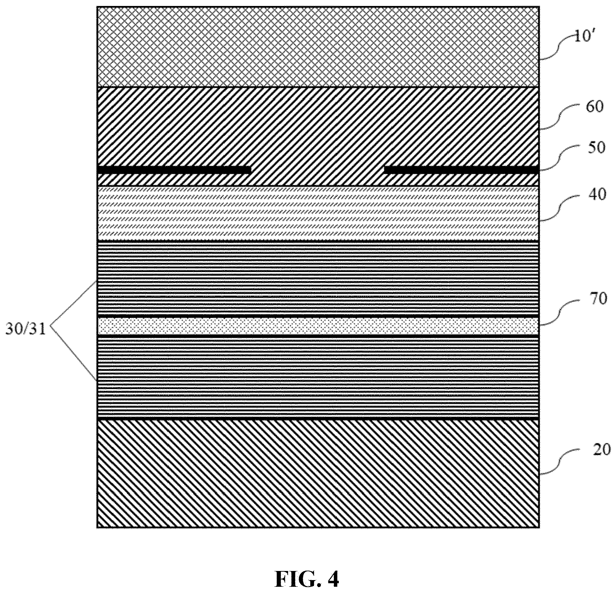

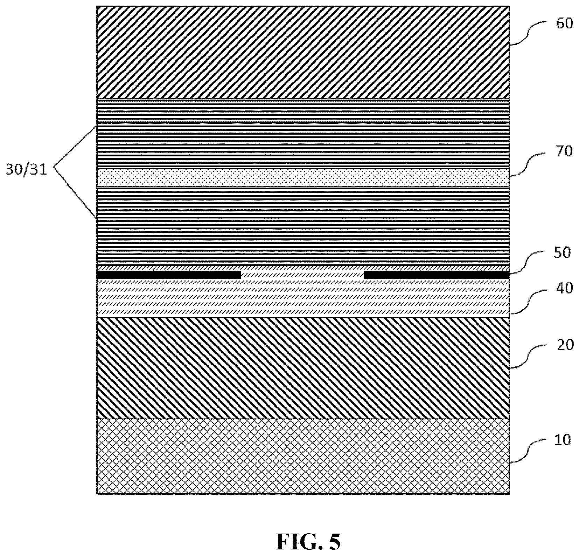

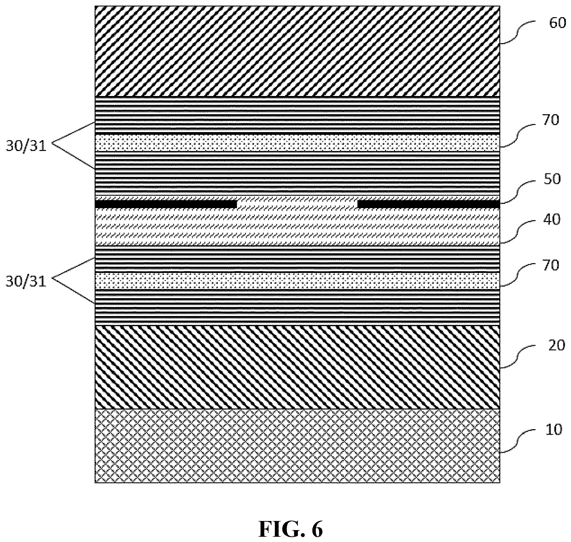

In view of this, an embodiment of the present application provides a VCSEL with a small divergence angle. FIG. 2 is a structural diagram of a VCSEL with a small divergence angle according to an embodiment of the present application, FIG. 3 is a structural diagram of another VCSEL with a small divergence angle according to an embodiment of the present application, FIG. 4 is a structural diagram of another VCSEL with a small divergence angle according to an embodiment of the present application, FIG. 5 is a structural diagram of another VCSEL with a small divergence angle according to an embodiment of the present application, and FIG. 6 is a structural diagram of another VCSEL with a small divergence angle according to an embodiment of the present application. Referring to FIG. 2 to FIG. 6, the VCSEL with a small divergence angle includes a lower Bragg reflection layer 20, an active layer 40 and an upper Bragg reflection layer 60.

The active layer 40 is located on a side of the lower Bragg reflection layer 20.

The upper Bragg reflection layer 60 is located on a side of the active layer 40 away from the lower Bragg reflection layer 20. A current limiting layer 50 is disposed inside or close to the active layer 40, and the current limiting layer 50 has an opening for defining a light-emitting region.

An extended cavity layer 30 is disposed at least between the lower Bragg reflection layer 20 and the active layer 40 or between the upper Bragg reflection layer 60 and the active layer 40, the extended cavity layer 30 includes at least one resonant cavity 70 inside, and the resonant cavity 70 is configured to increase the optical field intensity in the extended cavity layer 30.

For example, the lower Bragg reflection layer 20 may include multiple reflectors with an optical thickness of a quarter of a lasing wavelength, and the multiple reflectors are disposed by alternating reflectors with high refractive indexes and reflectors with low refractive indexes; and the upper Bragg reflection layer 60 may include multiple reflectors with an optical thickness of a quarter of the lasing wavelength, and the multiple reflectors are disposed by alternating reflectors with high refractive indexes and reflectors with low refractive indexes. The material of the upper Bragg reflection layer 60 and the material of the lower Bragg reflection layer 20 may be dielectric materials having electrical insulation properties, for example, may be silicon nitride, silicon oxide, aluminum oxide or titanium oxide. The material of the upper Bragg reflection layer 60 and the material of the lower Bragg reflection layer 20 may be semiconductor materials, for example, may be GaAs or AlGaAs. Referring to FIG. 3, FIG. 5 or FIG. 6, the VCSEL with a small divergence angle may further include a substrate 10. The substrate 10 is located on a side of the lower Bragg reflection layer 20 away from the active layer 40. The substrate 10 may be made of any material suitable for forming a laser, and the material of the substrate may be GaAs or Si. Referring to FIG. 4, the VCSEL with a small divergence angle may further include a transparent top lining 10'. The transparent top lining 10' is located on a side of the upper Bragg reflection layer 60 away from the active layer 40, and the material of the transparent top lining 10' includes sapphire, quartz, glass or transparent polymer.

The current limiting layer 50 is included at the edge of a layer close to the active layer 40 side. Alternatively, the current limiting layer 50 is disposed inside the active layer 40. The side wall of a semiconductor layer (for example, the material of the semiconductor layer is aluminum gallium arsenide) where the current limiting layer 50 is located may be oxidized to form the oxide layer in the manner of highly-aluminum-doped wet oxidation under certain temperature conditions so that the current limiting layer 50 is formed. The current limiting layer 50 has the opening for defining a light-emitting region of a laser. The aluminum oxide formed after being oxidized has relatively high impedance, and the material of the opening position of the current limiting layer 50 is still highly-aluminum-doped aluminum gallium arsenic. After the current is applied, the current will flow to the active layer 40 through the opening in the current limiting layer 50. The active layer 40 includes at least one quantum well, which may include quantum well composite structures in a laminated arrangement and composed of materials such as GaAs and AlGaAs which are in a laminated arrangement, InGaAs and GaAsP which are in a laminated arrangement or InGaAs and AlGaAs which are in a laminated arrangement, so that electrical energy is converted into light energy to generate laser light. For example, a quantum well group has 2 to 5 quantum wells, a potential barrier exists between quantum wells, and a potential barrier exists outside the quantum well group. The optical path distance between the center of each quantum well in a direction perpendicular to the active layer 40 and the peak value position of the closest standing wave optical field is less than one fifth of the lasing wavelength. When more than one quantum wells exist, the optical path distance between the central position of a group of quantum wells and the peak value position of the closest standing wave optical field is less than one tenth of the lasing wavelength. For example, the central position of the quantum well is aligned with the peak value of the electric field. Since the quantum well is the place where laser gain amplification occurs, the alignment of the central position of the quantum well with the position of the optical field having the highest intensity can generate a greater amplification effect.

The extended cavity layer 30 is disposed at least between the lower Bragg reflection layer 20 and the active layer 40 or between the upper Bragg reflection layer 60 and the active layer 40. FIG. 2 to FIG. 4 exemplarily illustrate the extended cavity layer 30 which is disposed between the lower Bragg reflection layer 20 and the active layer 40 and is parallel to the active layer 40. FIG. 5 exemplarily illustrates the extended cavity layer 30 which is disposed between the upper Bragg reflection layer 60 and the active layer 40 and is parallel to the active layer 40. FIG. 6 exemplarily illustrates the extended cavity layer 30 which is disposed between the lower Bragg reflection layer 20 and the active layer 40 and the extended cavity layer 30 which is disposed between the upper Bragg reflection layer 60 and the active layer 40, and the two extended cavity layers 30 are both parallel to the active layer 40. The extended cavity layer 30 includes the resonant cavity 70 inside, and the resonant cavity 70 is configured to increase the optical field intensity in the extended cavity layer 30 where the resonant cavity 70 is located. The resonant cavity 70 is disposed in the extended cavity layer 30, so that the optical field intensity in the extended cavity layer 30 is increased. The material of the extended cavity layer 30 may be a dielectric material or a semiconductor material.

It can be seen from the preceding formulas that reducing the value of the coefficient $\Gamma_{ox}$ can reduce the difference between effective refractive indexes inside and outside the light-emitting aperture of the VCSEL. Reducing the value of the coefficient $\Gamma_{ox}$ can be achieved by at least one of reducing the numerator of $\Gamma_{ox}$ or increasing the denominator of $\Gamma_{ox}$. The thickness of the current limiting layer 50 is relatively small, and lengthening the cavity length p in the denominator will cause longitudinal modes; therefore, in the embodiment of the present application, the electric field intensity $E^2$ in the denominator, that is, the optical field intensity in the extended cavity layer 30, is increased so that the difference between effective refractive indexes inside and outside the light-emitting aperture of the VCSEL is reduced, and thus the generation of the higher-order mode is suppressed and the divergence angle is reduced. Moreover, the optical field intensity inside the extended cavity layer 30 is increased, so that the increase of the cavity length can be reduced compared with the related art, and the problem may also be alleviated of multiple longitudinal modes appearing in the emission spectrum of the VCSEL; therefore, single longitudinal mode lasing is achieved and multi-wavelength output is avoided while the divergence angle is greatly reduced. In this manner, problems can be avoided that the temperature drift coefficient of the light source increases and the temperature stability decreases, and a receiving terminal of a three-dimensional sensor or laser radar cannot recognize the multi-wavelength, leading to reduced efficiency and crosstalk.

In summary, according to the VCSEL with a small divergence angle provided in the embodiment of the present application, the resonant cavity is disposed in the extended cavity layer, so that the optical field intensity in the extended cavity layer is increased, the difference between effective refractive indexes inside and outside the light-emitting aperture of the VCSEL is reduced, and thus the generation of the higher-order mode is suppressed and the divergence angle is reduced; moreover, the optical field intensity in the extended cavity layer is increased, so that the effective cavity length of the laser can be effectively reduced, the wavelength difference between adjacent longitudinal modes is increased, and thus single longitudinal mode lasing is achieved and multi-wavelength output is avoided. Therefore, single longitudinal mode lasing is achieved and multi-wavelength output is avoided while the divergence angle is greatly reduced.

For example, a small divergence angle may refer to that the divergence angle is less than 20 degrees.

In an embodiment, if the lower Bragg reflection layer 20 and the upper Bragg reflection layer 60 are made of semiconductor materials, the lower Bragg reflection layer 20 is an n-type semiconductor layer, and the upper Bragg reflection layer 60 is a p-type semiconductor layer; or the lower Bragg reflection layer 20 may be a p-type semiconductor layer, and the upper Bragg reflection layer 60 may be an n-type semiconductor layer. For a laser of which the current limiting layer 50 is disposed at the edge of a layer close to the active layer 40 side, if the upper Bragg reflection layer 60 is in direct contact with the active layer (referring to FIG. 2), the current limiting layer 50 is located inside the upper Bragg reflection layer 60; if the active layer 40 and the upper Bragg reflection layer 60 are separated by the extended cavity layer 30, the current limiting layer 50 is located inside the active layer 40 (referring to FIG. 5 to FIG. 6). FIG. 2 to FIG. 4 exemplarily illustrate positions where the current limiting layer 50 is located outside the active layer 40. To better define the light-emitting region, the current limiting layer 50 is located within a range of two wavelengths from a side of the active layer 40 in the direction perpendicular to the active layer 40.

The current limiting layer 50 may also be located inside the active layer 40. In this case, the optical path distance between the center of the current limiting layer 50 in the direction perpendicular to the active layer and a zero value position of the closest standing wave optical field is less than one tenth of the lasing wavelength. In this manner, the effect of defining the light-emitting region is ensured, and the optical field intensity at the position where the current limiting layer 50 is located can also be ensured to be relatively small; the optical confinement factor of the current limiting layer 50 can be further reduced, and thus the divergence angle of the far field is reduced. It is to be noted that at least one current limiting layer 50 is disposed. Sizes of openings of different current limiting layers 50 may be the same or different, and the light-emitting region defined by the current limiting layer 50 with the smallest opening serves as the light-emitting region of the laser.

FIG. 5 to FIG. 7 exemplarily illustrate positions where the current limiting layer 50 is located inside the active layer 40. To better define the light-emitting region, the optical path distance between the center of the current limiting layer 50 in the direction perpendicular to the active layer 40 and a zero value position of the closest standing wave optical field is less than one tenth of the lasing wavelength.

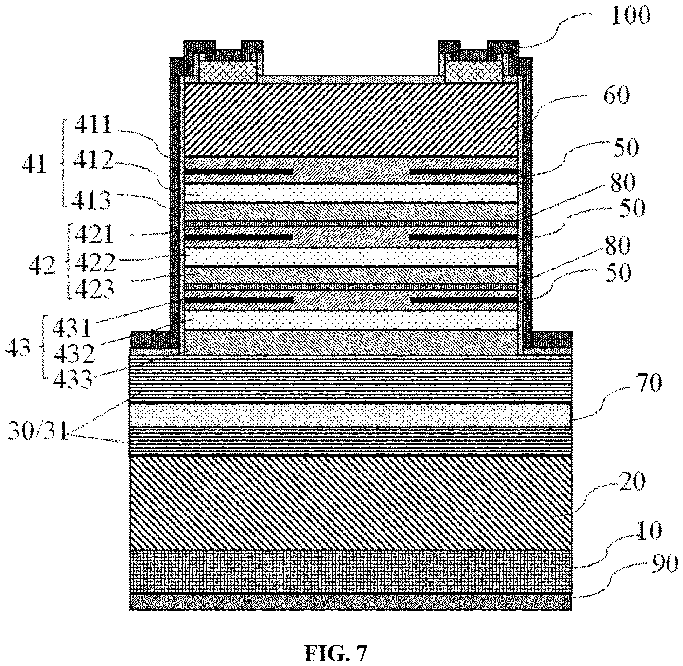

In an embodiment, FIG. 7 is a structural diagram of another VCSEL with a small divergence angle according to an embodiment of the present application. Referring to FIG. 7, the active layer 40 includes at least two groups of active sublayers (three groups of active sublayers, that is, 41, 42 and 43, are illustratively shown in FIG. 7 respectively), and each group of active sublayer is connected to another group of active layer by a tunnel junction 80. The optical path distance between the tunnel junction 80 and a zero value position of the closest standing wave optical field is less than one tenth of the lasing wavelength. In an embodiment, the tunnel junction 80 is located at the position where the intensity of the standing wave optical field is zero. The tunnel junction is highly doped, which will generate optical absorption loss and reduce light emission efficiency, so that the tunnel junction is provided at the position of the lowest optical field intensity to minimize the optical absorption loss.

Each active sublayer is provided with a quantum well (412/422/432). In the active sublayer, an n-type semiconductor layer (413/423/433) and a p-type semiconductor layer (411/421/431) are disposed on two sides of the quantum well respectively. For a laser of which the current limiting layer 50 for defining the light-emitting region is interposed in the active layer 40, the current limiting layer 50 is located in the p-type semiconductor layer (411/421/431). A first electrode layer 90 is disposed on a side of the substrate 10 away from the active layer 40, and a second electrode layer 100 is disposed on the side of the upper Bragg reflection layer 60 away from the active layer 40. A voltage difference is generated due to an external electrical signal received by the first electrode layer 90 and an external electrical signal received by the second electrode layer 100, so that a current is provided for the active layer 40. The center of the light limiting layer 50 is set at the position where the intensity of the standing wave optical field is zero, so that the value of the coefficient $\Gamma_{ox}$ can be reduced, then the difference between effective

refractive indexes inside and outside the light-emitting aperture of the VCSEL can be further reduced, and thus the divergence angle is reduced. In a structure of multiple active sublayers, only one current limiting layer 50 may be disposed, and the current limiting layer 50 is located in an active sublayer (41) closest to the upper Bragg reflection layer 60. In an embodiment, only one current limiting layer 50 is disposed, so that the effective refractive index of the current limiting layer 50 in the device can be reduced while the light-emitting region can be defined. It is to be noted that each active sublayer may include multiple quantum wells.

In an embodiment, the extended cavity layer 30 includes one resonant cavity 70 inside. In a direction pointing from the resonant cavity 70 to the active layer 40, peak values of optical field intensities from the resonant cavity 70 to the active layer 40 gradually decrease.

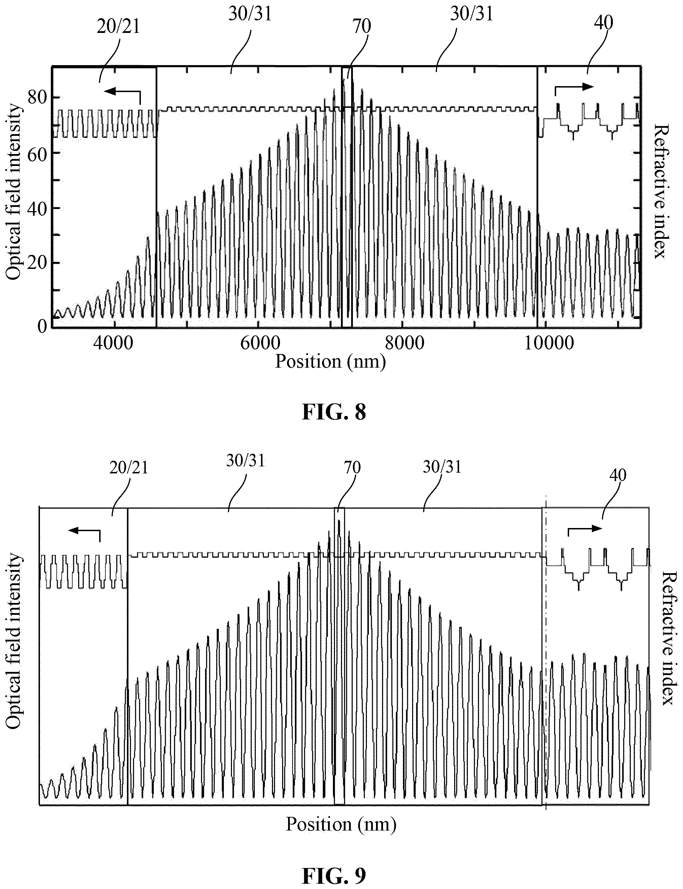

For example, the structure in FIG. 2 is taken as an example. The extended cavity layer 30 is located between the lower Bragg reflection layer 20 and the active layer 40, a side of the extended cavity layer 30 is in contact with the lower Bragg reflection layer 20, and the other side of the extended cavity layer 30 is in contact with the active layer 40. FIG. 8 is a profile showing the distribution of optical field intensities and the distribution of refractive indexes according to an embodiment of the present application, and FIG. 9 is another profile showing the distribution of optical field intensities and the distribution of refractive indexes according to an embodiment of the present application. Referring to FIG. 8 to FIG. 9, in the direction pointing from the resonant cavity 70 to the active layer 40, peak values of optical field intensities from the resonant cavity 70 to the active layer 40 gradually decrease. It may be understood as that the active layer 40 in the embodiment of the present application is configured to provide light, and the amplification of light is achieved by the resonant cavity 70 and extended cavity layers 30 located on two sides of the resonant cavity 70. The extended cavity layer 30 may include a Bragg reflection layer which is formed by laminating two material layers having different refractive indexes, that is, an aluminum gallium arsenic material layer and a gallium arsenide material layer, or by laminating two material layers having different refractive indexes, that is, an aluminum gallium arsenic material layer with high aluminum component and an aluminum gallium arsenic material layer with low aluminum component. Alternatively, the extended cavity layer 30 may also be formed by laminating two dielectric material layers having different refractive indexes. The optical thickness of the resonant cavity 70 is set to be an integer multiple of one half of the lasing wavelength, so that reflection directions of the Bragg reflection layers on two sides are opposite; therefore, the optical field intensity in the cavity of the resonant cavity 70 is highest, and in the direction pointing from the resonant cavity 70 to the active layer 40, optical field intensities from the resonant cavity 70 to the active layer 40 gradually decrease. The resonant cavity 70 is disposed in the extended cavity layer 30, so that the optical field intensity in the extended cavity layer 30 is increased, the difference between effective refractive indexes inside and outside the light-emitting aperture of the VCSEL is reduced, and thus the generation of the higher-order mode is suppressed and the divergence angle is reduced; moreover, the optical field intensity in the extended cavity layer 30 is increased, so that the increase of the cavity length can be reduced, and the problem may also be alleviated of multiple longitudinal modes appearing in the emission spectrum of the VCSEL; therefore, single longitudinal mode lasing is achieved and multi-wavelength output is avoided while the divergence angle is greatly reduced. For a laser (for example, the laser structure shown in FIG. 6) of which two sides of the active layer are both provided with extended cavity layers 30, in directions separately pointing from resonant cavities 70 located on two sides of the active layer 40 to the active layer 40, peak values of optical field intensities from the resonant cavities 70 on the two sides to the active layer 40 gradually decrease.

In addition, for the VCSEL with a small divergence angle provided in the embodiment of the present application, the optical field intensity in the resonant cavity 70 is highest, and in the direction pointing from the resonant cavity 70 to the active layer 40, optical field intensities from the resonant cavity 70 to the active layer 40 gradually decrease. The difference between the optical field intensity in the extended cavity layer 30 close to the edge of the active layer 40 and the optical field intensity in the active layer 40 is relatively small. The optical field intensity in the active layer 40 is less than the optical field intensity in the active layer 40 in the related art; therefore, the electric field intensity of the current limiting layer 50 located close to the active layer 40 side or the electric field intensity of the current limiting layer 50 located inside the active layer 40 may be reduced, and then the value of the coefficient $\Gamma_{ox}$ may be further

reduced, so that the difference between effective refractive indexes inside and outside the light-emitting aperture of the VCSEL is reduced, and the divergence angle of the laser is reduced.

In an embodiment, in the direction perpendicular to the active layer 40, a distance between the current limiting layer 50 and the active layer 40 is less than a distance between the resonant cavity 70 and the active layer 40.

For example, referring to FIG. 2, for the structure of which the current limiting layer is not located in the active layer 40, the distance between the current limiting layer 50 and the active layer 40 is less than the distance between the resonant cavity 70 and the active layer 40; referring to FIG. 5, for the structure of which the current limiting layer 50 is located inside the active layer 40, the distance between the current limiting layer 50 and the active layer 40 is less than the distance between the resonant cavity 70 and the active layer 40. It may be understood as that the current limiting layer 50 is located at the position close to the edge of the active layer 40, and the resonant cavity 70 is located at the position close to the middle of the extended cavity layer 30 or on a side in the extended cavity layer 30 away from the active layer 40. The current limiting layer 50 is located at the position close to the edge of the active layer 40, so that the difference between the size of the opening of the current limiting layer 50 and the size of the region where a current enters the active layer 40 is relatively small. The current limiting layer 50 is located at the position close to the edge of the active layer 40, and the resonant cavity 70 is located at the position close to the middle of the extended cavity layer 30 or on the side in the extended cavity layer 30 away from the active layer 40, so that the difference between the optical field intensity of the resonant cavity 70 and the optical field intensity of the active layer 40 can be increased. In an embodiment, in the direction perpendicular to the active layer 40, the distance between the resonant cavity 70 and the active layer 40 is greater than one half of the thickness of the extended cavity layer 30. In this manner, the optical field intensity of the oxide layer is further reduced, and then the value of the coefficient $\Gamma_{ox}$ can be further reduced, so that the difference between effective refractive indexes inside and outside the light-emitting aperture of the VCSEL is reduced, and the divergence angle of the laser is reduced.

In an embodiment, with continued reference to FIG. 2 to FIG. 6, the extended cavity layer is a middle Bragg reflection layer 31.

The lower Bragg reflection layer 20 includes multiple reflectors with an optical thickness of a quarter of the lasing wavelength, and the multiple reflectors are disposed by alternating reflectors with high refractive indexes and reflectors with low refractive indexes.

The upper Bragg reflection layer 60 includes multiple reflectors with an optical thickness of a quarter of the lasing wavelength, and the multiple reflectors are disposed by alternating reflectors with high refractive indexes and reflectors with low refractive indexes.

The middle Bragg reflection layer 31 includes multiple reflectors with an optical thickness of a quarter of the lasing wavelength, and the multiple reflectors are disposed by alternating reflectors with high refractive indexes and reflectors with low refractive indexes.

For example, the lower Bragg reflection layer 20 may include the lower Bragg reflection layer 20 which is formed by laminating two material layers having different refractive indexes, that is, an aluminum gallium arsenic material layer and a gallium arsenide material layer, or by laminating two material layers having different refractive indexes, that is, an aluminum gallium arsenic material layer with high aluminum component and an aluminum gallium arsenic material layer with low aluminum component, and the optical thickness of each material layer is a quarter of the lasing wavelength. The upper Bragg reflection layer 60 may include the upper Bragg reflection layer 60 which is formed by laminating two material layers having different refractive indexes, that is, an aluminum gallium arsenic material layer and a gallium arsenide material layer, or by laminating two material layers having different refractive indexes, that is, an aluminum gallium arsenic material layer with high aluminum component and an aluminum gallium arsenic material layer with low aluminum component, and the optical thickness of each material layer is a quarter of the lasing wavelength. The extended cavity layer 30 may include a middle Bragg reflection layer 31 which is formed by laminating two material layers having different refractive indexes, that is, an aluminum gallium arsenic material layer and a gallium arsenide material layer, or by laminating two material layers having different refractive indexes, that is, an aluminum gallium arsenic material layer with high aluminum component and an aluminum gallium arsenic material layer with low aluminum component, and the optical thickness of each material layer is a quarter of the lasing wavelength.

The lower Bragg reflection layer 20 may also be formed by laminating two dielectric material layers having different refractive indexes, and the optical thickness of each material layer is a quarter of the lasing wavelength. The upper Bragg reflection layer 60 may be formed by laminating two dielectric material layers having different refractive indexes, and the optical thickness of each material layer is a quarter of the lasing wavelength. The extended cavity layer 30 may include a middle Bragg reflection layer 31 which is formed by laminating two dielectric material layers having different refractive indexes, and the optical thickness of each material layer is a quarter of the lasing wavelength.

In an embodiment, contrast between a high refractive index and a low refractive index in each half-wavelength period of the middle Bragg reflection layer 31 is lower than contrast between a high refractive index and a low refractive index in a corresponding half-wavelength period of the lower Bragg reflection layer 20 and/or contrast between a high refractive index and a low refractive index in a corresponding half-wavelength period of the upper Bragg reflection layer 60.

For example, referring to FIG. 8, the contrast between refractive indexes in each half-wavelength period of the middle Bragg reflection layer 31 being lower than the contrast between refractive indexes in the corresponding half-wavelength period of the upper Bragg reflection layer and/or the contrast between refractive indexes in the corresponding half-wavelength period of the lower Bragg reflection layer may be understood as that the difference between the high refractive index and the low refractive index in each half-wavelength period of the middle Bragg reflection layer 31 or the ratio of the high refractive index to the low refractive index in each half-wavelength period of the middle Bragg reflection layer 31 is less than the difference between the high refractive index and the low refractive index in each half-wavelength period of the lower (and/or upper) Bragg reflection layer or the ratio of the high refractive index to the low refractive index in each half-wavelength period of the lower (and/or upper) Bragg reflection layer. The contrast between refractive indexes in each half-wavelength period of the middle Bragg reflection layer 31 is relatively low, so that it is avoided that a fewer pairs of reflectors make the optical field intensity in the resonant cavity 70 very high due to too high contrast. That is, the contrast between refractive indexes in each half-wavelength period of the middle Bragg reflection layer 31 is relatively low, so that the middle Bragg reflection layer 31 includes multiple pairs of reflectors, and then the thickness of the middle Bragg reflection layer 31 can be ensured to satisfy the requirements for achieving single longitudinal mode lasing and avoiding multi-wavelength output while greatly reducing the divergence angle.

In summary, the thickness of the middle Bragg reflection layer 31 is inversely related to the contrast between the high refractive index and the low refractive index in each half-wavelength period of the middle Bragg reflection layer 31. The number of pairs of reflectors included in the middle Bragg reflection layer 31 has a relationship with the contrast between the high refractive index and the low refractive index in each half-wavelength period of the middle Bragg reflection layer 31. If the contrast is high (for example, the contrast is $Al0.1GaAs/Al0.9GaAs$), fewer pairs of reflectors may be set, and thus the middle Bragg reflection layer 31 is thinner, so that it is avoided that a fewer pairs of reflectors make the optical field intensity in the resonant cavity 70 very high due to too high contrast. Conversely, if the contrast is low (for example, the contrast is $Al0.1GaAs/Al0.15GaAs$), more pairs of reflectors may be set, and thus the middle Bragg reflection layer 31 is thicker, so that the requirements for the optical field intensity in the resonant cavity 70 becoming high are satisfied. The thickness of the total cavity length of the extended cavity layer 30 may be set to range from 5 um to 20 um. The longer the cavity length and the higher the electric field intensity of the extended cavity layer 30, the better the effect of reducing the divergence angle. In an embodiment, the cavity length may be set to be greater than 20 um. It is to be noted that the thickness of the extended cavity layer 30 needs to satisfy the requirements for avoiding longitudinal modes.

In an embodiment, the extended cavity layer 30 includes a resonant cavity 70 and two groups of middle Bragg refection layers 31. One group of middle Bragg reflection layer 31 of the two groups of middle Bragg reflection layers 31 is located between the resonant cavity 70 and the lower Bragg reflection layer 20, and the other group of middle Bragg reflection layer 31 of the two groups of middle Bragg reflection layers 31 is located between the resonant cavity 70 and the active layer 40. It may be understood as that the resonant cavity 70 is interposed within the extended cavity layer 30, dividing the extended cavity layer 30 into two parts. One part of the two parts is located between the resonant cavity 70 and the lower Bragg reflection layer 20, and the other part of the two parts is located between the resonant cavity 70 and the active layer 40. Reflectivity of the middle Bragg reflection layer 31 between the resonant cavity 70 and the lower Bragg reflection layer 20 is less than reflectivity of the middle Bragg reflection layer 31 between the resonant cavity 70 and the active layer 40. If the two groups of middle Bragg reflection layers 31 are made of the same materials having alternate high and low refractive indexes, the number of periods of the middle Bragg reflection layer 31 between the resonant cavity 70 and the lower Bragg reflection layer 20 may be smaller than the number of periods of the middle Bragg reflection layer between the resonant cavity 70 and the active layer 40, the reflectivity of the middle Bragg reflection layer 31 between the resonant cavity 70 and the lower Bragg reflection layer 20 may be less than the reflectivity of the middle Bragg reflection layer 31 between the resonant cavity 70 and the active layer 40, and in the direction perpendicular to the active layer 40, the distance between the resonant cavity 70 and the active layer 40 is greater than one half of the thickness of the extended cavity layer 30. Thus, the difference between the optical field intensity of the resonant cavity 70 and the optical field intensity of the active layer 40 can be increased. In this manner, the optical field intensity of the oxide layer is further reduced, and then the value of the coefficient $\Gamma_{ox}$ can be further reduced, so that the difference between effective refractive indexes inside and outside the light-emitting aperture of the VCSEL is reduced, and the divergence angle of the laser is reduced.

For example, the periodic structure of the middle Bragg reflector layer refers to a periodic structure formed by periodically arranging two materials having different refractive indexes in the z-axis direction. Each period of the Bragg structure has two layers, that is, a pair. The number of periods of the middle Bragg reflection layer refers to the number of periodic structures in the middle Bragg reflection layer.

In an embodiment, a refractive index of the resonant cavity 70 is different from a refractive index of a portion of the middle Bragg reflection layer 31 in contact with the resonant cavity 70.

For example, referring to FIG. 8, the refractive index of the resonant cavity 70 is higher than the refractive index of the portion of the middle Bragg reflection layer 31 in contact with the resonant cavity 70. At this time, the maximum value of the optical field intensity in the resonant cavity 70 is located at the position of the interface between the resonant cavity 70 and the middle Bragg reflection layer 31. The structure shown in FIG. 2 is still taken as an example. Referring to FIG. 9, the refractive index of the resonant cavity 70 is lower than the refractive index of the portion of the middle Bragg reflection layer 31 in contact with the resonant cavity 70. At this time, the maximum value of the optical field intensity in the resonant cavity 70 is located at the position of the middle of the resonant cavity 70. In an embodiment, the resonant cavity 70 includes multiple sublayers of different materials. The materials may include AlGaAs, GaAsP, InGaAs, 1GaN, etc.

In an embodiment, a light-emitting surface or a main light-emitting surface of lasers is located on the side of the lower Bragg reflection layer 20 away from the active layer 40, and reflectivity of the upper Bragg reflection layer 60 is greater than reflectivity of the lower Bragg reflection layer 20.

Alternatively, a light-emitting surface or a main light-emitting surface of lasers is located on the side of the upper Bragg reflection layer 60 away from the active layer 40, and reflectivity of the lower Bragg reflection layer 20 is greater than reflectivity of the upper Bragg reflection layer 60.

For example, if the light-emitting surface of lasers is located on the side of the lower Bragg reflection layer 20 away from the active layer 40, total reflectivity of reflectors included in the upper Bragg reflection layer 60 is greater than total reflectivity of reflectors included in the lower Bragg reflection layer 20, so that the upper Bragg reflection layer 60 can achieve total reflection, the lower Bragg reflective layer 20 can transmit light, and the light-emitting direction of the laser is a direction pointing from the active layer 40 to the lower Bragg reflection layer 20, that is, the laser is a back-emitting laser. If the light-emitting surface of lasers is located on the side of the upper Bragg reflection layer 60 away from the active layer 40, total reflectivity of reflectors included in the lower Bragg reflection layer 20 is greater than total reflectivity of reflectors included in the upper Bragg reflection layer 60, so that the lower Bragg reflection layer 20 can achieve total reflection, the upper Bragg reflective layer 60 can transmit light, and the light-emitting direction of the laser is the direction pointing from the active layer 40 to the upper Bragg reflection layer 60, that is, the laser is a top-emitting laser. If contrast between refractive indexes (for example, the contrast between refractive indexes may be the absolute value of the difference between the refractive index of an upper reflector and the refractive index of a lower reflector) of each pair of reflectors (for example, each pair of reflectors includes an upper reflector and a lower reflector) in the upper Bragg reflection layer 60 is the same as contrast between refractive indexes of each pair of reflectors in the lower Bragg reflection layer 20, when the light-emitting surface of lasers is located on the side of the lower Bragg reflection layer 20 away from the active layer 40, the number of pairs of reflectors included in the upper Bragg reflection layer 60 is set to be larger than the number of pairs of reflectors included in the lower Bragg reflection layer 20; when the light-emitting surface of lasers is located on the side of the upper Bragg reflection layer 60 away from the active layer 40, the number of pairs of reflectors included in the lower Bragg reflection layer 20 is set to be larger than the number of pairs of reflectors included in the upper Bragg reflection layer 60. In an embodiment, a microlens may be further provided. The microlens is integrated on a side of the light-emitting surface for further reducing the divergence angle of the far field.

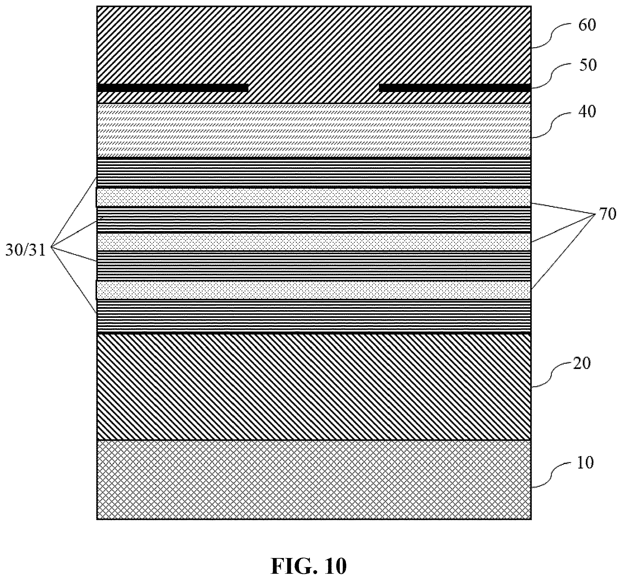

For example, FIG. 10 is a structural diagram of another VCSEL with a small divergence angle according to an embodiment of the present application. Referring to FIG. 10, multiple resonant cavities 70 are included inside the extended cavity layer 30, and the highest peak value of the optical field intensity in at least one resonant cavity 70 is greater than the highest peak value of the optical field intensity of the active layer.

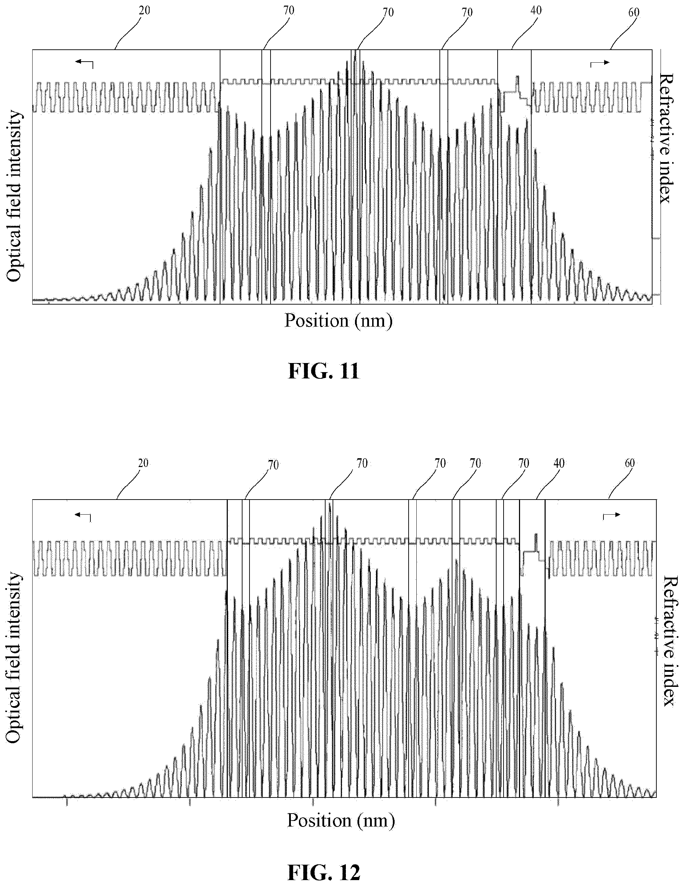

In an embodiment, multiple cavity bodies with an optical thickness of an integer multiple of half a wavelength are disposed inside the extended cavity layer 30. For example, FIG. 10 illustratively shows three cavities with the optical thickness of an integer multiple of half the wavelength. For a laser having multiple resonant cavities 70, the optical field intensity of at least one resonant cavity 70 is greater than the optical field intensity of the active layer. FIG. 11 is a profile showing the distribution of optical field intensities and the distribution of refractive indexes according to an embodiment of the present application. Referring to FIG. 11, three cavities with the optical thickness of an integer multiple of half the wavelength are disposed, and one of the three cavities forms a true resonant cavity with a high optical field intensity. FIG. 12 is another profile showing the distribution of optical field intensities and the distribution of refractive indexes according to an embodiment of the present application. Referring to FIG. 12, five cavities with the optical thickness of an integer multiple of half the wavelength are disposed, and two of the five cavities form true resonant cavities with high optical field intensities. In an embodiment, a single half-wave cavity (for example, structures show in FIG. 2 to FIG. 7) is disposed in the extended cavity layer 30. If a single half-wave cavity is disposed, the difference between the optical field intensity in the cavity and the optical field intensity in the active layer can be relatively large, so that the divergence angle is further reduced.

An embodiment of the present application further provides a VCSEL chip with a small divergence angle including multiple VCSELs with a small divergence angle according to any of the preceding embodiments, and the multiple VCSELs with a small divergence angle are arranged in an array or arranged randomly. The VCSEL chip with a small divergence angle has the same technical effect as the VCSEL with a small divergence angle, which is not repeated here.

In an embodiment, the multiple VCSELs with a small divergence angle may form a planar array arrangement.

In an embodiment, the planar array arrangement may be multiple subarrays for addressing. Addressing refers to that one or more of the subarrays may be illuminated individually.

For example, a VCSEL may have 600 light-emitting points forming a $20 \times 30$ array of light-emitting points. The VCSEL may further divide the $20 \times 30$ array of light emitting points into different subarrays, for example, $2 \times 3$ subarrays, each subarray having $10 \times 10$ light-emitting points. Each subarray can be individually controlled.

An embodiment of the present application further provides a light source for a light detection and ranging (LIDAR) system. The light source includes at least one VCSEL with a small divergence angle according to any of the preceding embodiments or at least one VCSEL chip with a small divergence angle according to any of the preceding embodiments. The light source has the same technical effect as the VCSEL with a small divergence angle or the VCSEL chip with a small divergence angle, which is not repeated here.

The above are only some embodiments of the present application and the technical principles used therein. It is to be understood by those skilled in the art that the present application is not limited to the embodiments described herein. For those skilled in the art, various apparent modifications, adaptations and substitutions may be made without departing from the scope of the present application. Therefore, while the present application is described in detail in connection with the preceding embodiments, the present application is not limited to the preceding embodiments and may include more equivalent embodiments without departing from the concept of the present application. The scope of the present application is determined by the scope of the appended claims.

## Claims

1. A vertical-cavity surface-emitting laser (VCSEL) with a small divergence angle, comprising:

   a lower Bragg reflection layer (20);
   an active layer (40) located on a side of the lower Bragg reflection layer (20); and
   an upper Bragg reflection layer (60) located on a side of the active layer (40) away from the lower Bragg reflection layer (20); wherein a current limiting layer (50) is disposed inside or outside the active layer (40), and the current limiting layer (50) has an opening for defining a light-emitting region;
   wherein an extended cavity layer (30) is disposed at least between the lower Bragg reflection layer (20) and the active layer (40) or between the upper Bragg reflection layer (60) and the active layer (40), the extended cavity layer (30) comprises at least one resonant cavity (70) inside, and the at least one resonant cavity (70) is configured to increase an optical field intensity in the extended cavity layer (30).

2. The VCSEL with the small divergence angle according to claim 1, wherein the extended cavity layer (30) comprises one resonant cavity (70), and in a direction pointing from the one resonant cavity (70) to the active layer (40), peak values of optical field intensities from the one resonant cavity (70) to the active layer (40) gradually decrease.

3. The VCSEL with the small divergence angle according to claim 1, wherein the extended cavity layer (30) comprises a plurality of resonant cavities (70), and a highest peak value of an optical field intensity in at least one resonant cavity (70) of the plurality of resonant cavities (70) is greater than a highest peak value of an optical field intensity of the active layer (40).

4. The VCSEL with the small divergence angle according to claim 1, wherein an optical thickness of each resonant cavity (70) of the at least one resonant cavity (70) is an integer multiple of one half of a lasing wavelength.

5. The VCSEL with the small divergence angle according to claim 1, wherein the current limiting layer (50) comprises an oxide layer; the oxide layer is made of epitaxially-grown AlGaAs with high Al component, and an outer oxidized region in the oxide layer forms an insulated aluminum oxide film layer; and an unoxidized region in the oxide layer forms a light-emitting region for effective current injection.

6. The VCSEL with the small divergence angle according to claim 1, wherein

at least one current limiting layer (50) is disposed, and an optical path distance between each of the at least one current limiting layer (50) and a zero value position of a closest standing wave optical field is less than one tenth of a lasing wavelength; and in a case where the at least one current limiting layer (50) is located outside the active layer (40), the at least one current limiting layer (50) is located within a range of two wavelengths from a side of the active layer (40) in a direction perpendicular to the active layer (40); and
the active layer (40) comprises at least one quantum well, an optical path distance between each quantum well of the at least one quantum well and a peak value position of a closest standing wave optical field is less than one fifth of the lasing wavelength; and in a case where the active layer (40) comprises more than one quantum well, an optical path distance between a central position of a group of quantum wells and a peak value position of a closest standing wave optical field is less than one tenth of the lasing wavelength.

7. The VCSEL with the small divergence angle according to claim 6, wherein
each of the at least one current limiting layer (50) is located at a peak value position of a standing wave optical field, and the at least one quantum well is located at a zero value position of a standing wave optical field.

8. The VCSEL with the small divergence angle according to claim 1, wherein in a direction perpendicular to the active layer (40), a distance between the current limiting layer (50) and the active layer (40) is less than a distance between each resonant cavity (70) of the at least one resonant cavity (70) and the active layer (40).

9. The VCSEL with the small divergence angle according to claim 8, wherein in the direction perpendicular to the active layer (40), the distance between the each resonant cavity (70) and the active layer (40) is greater than one half of a thickness of the extended cavity layer (30).

10. The VCSEL with the small divergence angle according to claim 1, wherein

the extended cavity layer (30) comprises a middle Bragg reflection layer (31);
the lower Bragg reflection layer (20) comprises a plurality of reflectors which have an optical thickness of a quarter of a lasing wavelength and are disposed by alternating reflectors with high refractive indexes and reflectors with low refractive indexes;
the upper Bragg reflection layer (60) comprises a plurality of reflectors which have an optical thickness of a quarter of the lasing wavelength and are disposed by alternating reflectors with high refractive indexes and reflectors with low refractive indexes; and
the middle Bragg reflection layer (31) comprises a plurality of reflectors which have an optical thickness of a quarter of the lasing wavelength and are disposed by alternating reflectors with high refractive indexes and reflectors with low refractive indexes.

11. The VCSEL with the small divergence angle according to claim 10, wherein contrast between a high refractive index and a low refractive index in each half-wavelength period of the middle Bragg reflection layer (31) is lower than at least one of contrast between a high refractive index and a low refractive index in a corresponding half-wavelength period of the lower Bragg reflection layer (20) or contrast between a high refractive index and a low refractive index in a corresponding half-wavelength period of the upper Bragg reflection layer (60).

12. The VCSEL with the small divergence angle according to claim 10, wherein the extended cavity layer (30) comprises a resonant cavity (70) and two groups of middle Bragg refection layers (31), one group of middle Bragg reflection layers (31) of the two groups of middle Bragg reflection layers (31) is located between the resonant cavity (70) and the lower Bragg reflection layer (20), and another group of middle Bragg reflection layers (31) of the two groups of middle Bragg reflection layers (31) is located between the resonant cavity (70) and the active layer (40).

13. The VCSEL with the small divergence angle according to claim 12, wherein reflectivity of one group of middle Bragg reflection layers (31) between the resonant cavity (70) and the lower Bragg reflection layer (20) is less than reflectivity of another group of middle Bragg reflection layers (31) between the resonant cavity (70) and the active layer (40).

14. The VCSEL with the small divergence angle according to claim 13, wherein the two groups of middle Bragg reflection layers (31) are made of same materials having alternate high and low refractive indexes, and a number of periods of one group of middle Bragg reflection layer (31) between the resonant cavity (70) and the lower Bragg reflection layer (20) is smaller than a number of periods of another group of middle Bragg reflection layer (31) between the resonant cavity (70) and the active layer (40).

15. The VCSEL with the small divergence angle according to claim 10, wherein a refractive index of the at least one resonant cavity (70) is different from a refractive index of a portion of the middle Bragg reflection layer (31) in contact with the at least one resonant cavity (70).

16. The VCSEL with the small divergence angle according to claim 10, wherein

a light-emitting surface of a laser is located on a side of the lower Bragg reflection layer (20) away from the active layer (40), and reflectivity of the upper Bragg reflection layer (60) is greater than reflectivity of the lower Bragg reflection layer (20); or
a light-emitting surface of a laser is located on a side of the upper Bragg reflection layer (60) away from the active layer (40), and reflectivity of the lower Bragg reflection layer (20) is greater than reflectivity of the upper Bragg reflection layer (60).

17. The VCSEL with the small divergence angle according to claim 16, further comprising a microlens, wherein the microlens is integrated on a side of the light-emitting surface for reducing a divergence angle of a far field.

18. The VCSEL with the small divergence angle according to claim 10, wherein a thickness of the middle Bragg reflection layer (31) is inversely related to contrast between a high refractive index and a low refractive index in each half-wavelength period of the middle Bragg reflection layer (31).

19. The VCSEL with the small divergence angle according to claim 1, wherein each resonant cavity (70) of the at least one resonant cavity (70) comprises a plurality of sublayers of different materials.

20. The VCSEL with the small divergence angle according to claim 6, wherein the active layer (40) comprises at least two active sublayers, each active sublayer of the at least two active sublayers comprises at least one quantum well, and two adjacent active sublayers of the at least two active sublayers are connected by a tunnel junction (80); and an optical path distance between the tunnel junction (80) and a zero value position of a closest standing wave optical field is less than one tenth of the lasing wavelength.

21. The VCSEL with the small divergence angle according to claim 20, wherein at least one side of the each active sublayer has the extended cavity layer (30) and the at least one resonant cavity (70) disposed in the extended cavity layer (30).

22. The VCSEL with the small divergence angle according to claim 20, wherein at most one current limiting layer (50) exists in the each active sublayer; and the tunnel junction (80) is located at a zero value position of a standing wave optical field.

23. The VCSEL with the small divergence angle according to claim 1, wherein at least one of a material of the upper Bragg reflection layer (60), a material of the lower Bragg reflection layer (20) or a material of the extended cavity layer (30) is a dielectric material.

24. The VCSEL with the small divergence angle according to claim 1, wherein at least one of a material of the upper Bragg reflection layer (60), a material of the lower Bragg reflection layer (20) or a material of the extended cavity layer (30) is a semiconductor material.

25. The VCSEL with the small divergence angle according to claim 24, wherein

the lower Bragg reflection layer (20) is an n-type semiconductor layer, and the upper Bragg reflection layer (60) is a p-type semiconductor layer; or
the lower Bragg reflection layer (20) is a p-type semiconductor layer, and the upper Bragg reflection layer (60) is an n-type semiconductor layer.

26. The VCSEL with the small divergence angle according to claim 1, further comprising a substrate (10), wherein the substrate (10) is located on a side of the lower Bragg reflection layer (20) away from the active layer (40), and a material of the substrate (10) comprises GaAs or Si.

27. The VCSEL with the small divergence angle according to claim 1, further comprising a transparent top lining (10'), wherein the transparent top lining (10') is located on a side of the upper Bragg reflection layer (60) away from the active layer (40), and a material of the transparent top lining (10') comprises sapphire, quartz, glass or transparent polymer.

28. A vertical-cavity surface-emitting laser (VCSEL) chip with a small divergence angle, comprising a plurality of VCSELs with a small divergence angle according to any one of claims 1 to 27, wherein the plurality of VCSELs with a small divergence angle form a planar array arrangement; and the planar array arrangement is a regular arrangement, a random arrangement, or a plurality of subarrays for addressing.

29. A light source for a LIDAR system, comprising at least one vertical-cavity surface-emitting laser (VCSEL) with the small divergence angle according to any one of claims 1 to 27, or at least one VCSEL chip with the small divergence angle according to claim 28.

z

6

5

4

3

2

1

**FIG. 1**

**FIG. 2**

**FIG. 3**

**FIG. 4**

**FIG. 5**

30/31

60

70

30/31

50

40

70

20

10

**FIG. 6**

**FIG. 7**

**FIG. 8**

**FIG. 9**

EP 4 290 710 A1

**FIG. 10**

**FIG. 11**

**FIG. 12**

## INTERNATIONAL SEARCH REPORT

<table>
<tr><td></td><td>International application No.<br>**PCT/CN2022/083263**</td></tr>
</table>

| A. | CLASSIFICATION OF SUBJECT MATTER |
| --- | --- |
| | H01S 5/183(2006.01)i; H01S 5/10(2021.01)i; H01S 5/42(2006.01)i |

According to International Patent Classification (IPC) or to both national classification and IPC

| B. | FIELDS SEARCHED |
| --- | --- |

Minimum documentation searched (classification system followed by classification symbols)

    H01S5

Documentation searched other than minimum documentation to the extent that such documents are included in the fields searched

Electronic data base consulted during the international search (name of data base and, where practicable, search terms used)

    CNABS; CNTXT; VEN; WOTXT; EPTXT; USTXT; CNKI; 百度学术, BAIDU SCHOLAR; Web of Science: 窄, 低, 小, 扩散, 发散, 角, 高阶, 纵模, 强度, 折射率, 差, narrow, low, small, diffusion, divergence, angle, high+, order, longitudinal, mode, intensity, refractive, index, difference

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 111771312 A (PRINCETON OPTRONICS INC.) 13 October 2020 (2020-10-13)<br>    description, paragraphs [0019]-[0041], and figures 1-8 | 1-29 |
| X | CN 111758193 A (PRINCETON OPTRONICS INC.) 09 October 2020 (2020-10-09)<br>    description, paragraphs [0018]-[0034], and figures 1-7 | 1-29 |
| A | CN 112567580 A (AMS SENSORS ASIA PTE. LTD.) 26 March 2021 (2021-03-26)<br>    entire document | 1-29 |
| A | CN 110429473 A (INSTITUTE OF SEMICONDUCTORS, CHINESE ACADEMY OF SCIENCES) 08 November 2019 (2019-11-08)<br>    entire document | 1-29 |

☐ Further documents are listed in the continuation of Box C.     ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **11 May 2022** | **06 June 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/083263**

| Patent document cited in search report | | | Publication date (day/month/year) | Patent family member(s) | | | Publication date (day/month/year) |
|---|---|---|---|---|---|---|---|
| CN | 111771312 | A | 13 October 2020 | WO | 2019133655 | A1 | 04 July 2019 |
| | | | | EP | 3732756 | A1 | 04 November 2020 |
| | | | | US | 2021057888 | A1 | 25 February 2021 |
| | | | | TW | 201937820 | A | 16 September 2019 |
| | | | | EP | 3732756 | A4 | 18 August 2021 |
| CN | 111758193 | A | 09 October 2020 | WO | 2019133630 | A1 | 04 July 2019 |
| | | | | US | 2021057883 | A1 | 25 February 2021 |
| | | | | EP | 3732757 | A1 | 04 November 2020 |
| | | | | TW | 201933708 | A | 16 August 2019 |
| | | | | EP | 3732757 | A4 | 13 October 2021 |
| CN | 112567580 | A | 26 March 2021 | US | 2021281049 | A1 | 09 September 2021 |
| | | | | TW | 202025585 | A | 01 July 2020 |
| | | | | DE | 112019004094 | T5 | 02 June 2021 |
| | | | | WO | 2020036535 | A1 | 20 February 2020 |
| CN | 110429473 | A | 08 November 2019 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63249998

- CN 202111335318